# EUROPÄISCHE PATENTSCHRIFT

(11) **EP 0 303 815 B1**
(45) Veröffentlichungstag und Bekanntmachung des Hinweises auf die Patenterteilung: **22.09.1993**
(21) Anmeldenummer: 88110739.5
(22) Anmeldetag: 05.07.1988
(51) Int. Cl.: G11C 7/06

(54) **Leseverstärker für statische Speicher in CMOS-Technologie**
Sense amplifier for a CMOS static memory
Amplificateur de lecture pour mémoire statique en technologie CMOS

(30) Priorität: 18.08.1987 DE 3727558
(43) Veröffentlichungstag der Anmeldung: 22.02.1989
(73) Patentinhaber: SIEMENS AKTIENGESELLSCHAFT, 80333 München (DE)
(72) Erfinder: Althoff, Klaus, Dipl.-Ing., D-8000 München 80 (DE); Mattausch, Hans Jürgen, Dr. rer. nat., D-8011 Kirchheim (DE); Neuendorf, Gerd, Dipl.-Ing., D-8034 Germering (DE)

(56) Entgegenhaltungen:
- US-A- 4 136 292
- IEEE JOURNAL OF SOLID-STATE CIRCUITS, vol. SC-19, no. 5, October 1984, pages 578-585, New York, US; T. SAKURAI et al.: "A low power 46 ns 256 kbit CMOS static RAM with dynamic double word line"

## Beschreibung

Die Erfindung betrifft einen Leseverstärker, bestehend aus mindestens einem Lastteil, mindestens einem Differenzverstärker und einem Ausgleichstransistor.

Der in der Erfindung beschriebene Leseverstärker findet hauptsächlich in statischen Speichern (SRAMs) Verwendung. Dabei bildet ein SRAM einen Speicher, bei dem man nach Vorgabe einer Adresse Daten unter dieser Adresse abspeichern und wieder auslesen kann (wahlfreier Zugriff). Dabei werden aus technologischen Gründen einzelne Speicherzellen nicht linear, sondern in einer quadratischen Matrix angeordnet. Statische Speicher (SRAMs) werden vorzugsweise in kleineren Rechnersystemen eingesetzt, wo ihre höheren Kosten gegenüber dynamischen Speichern (DRAMs) durch eine einfache und kostengünstigere Systemarchitektur kompensiert werden. Frühere Entwicklungen für statische Speicher ergaben drei verschiedene Halbleitertechnologien: 1. Die Bipolartechnik, 2. die NMOS-Technik und 3. die CMOS-Technik. Letztere Technik wird für den erfindungsgemäßen Leseverstärker, der als einen wichtigen funktionellen Bestandteil von statischen Speichern zu betrachten ist, eingesetzt.

In einem statischen Speicher sind aufgrund der einfachen peripheren Schaltungen über 60 % der Chipfläche mit Speicherzellen abgedeckt. Der Rest der Chipfläche wird hauptsächlich für Zeilen und Spaltendecodierer sowie für Eingangs- und für Leseverstärker verwendet.

Die schaltungstechnische Ausbildung des Leseverstärkers hat einen entscheidenden Einfluß auf wichtige Kenndaten des statischen Speichers. So werden beispielsweise Zugriffszeit und die Verlustleistung durch die Eigenschaften des Leseverstärkers entscheidend mitbestimmt.

Der Stand der Technik bei Leseverstärkern für statische CMOS-Speicher ist in den folgenden Veröffentlichungen beschrieben:
1) Childs et al, IEEE J. Solid State Circuits, Vol. SC-19, S. 545-551, Okt. 1984 und
2) Okazaki et al, IEEE J. Solid State Circuits, Vol. SC-19, S. 552-556, Okt. 1984.

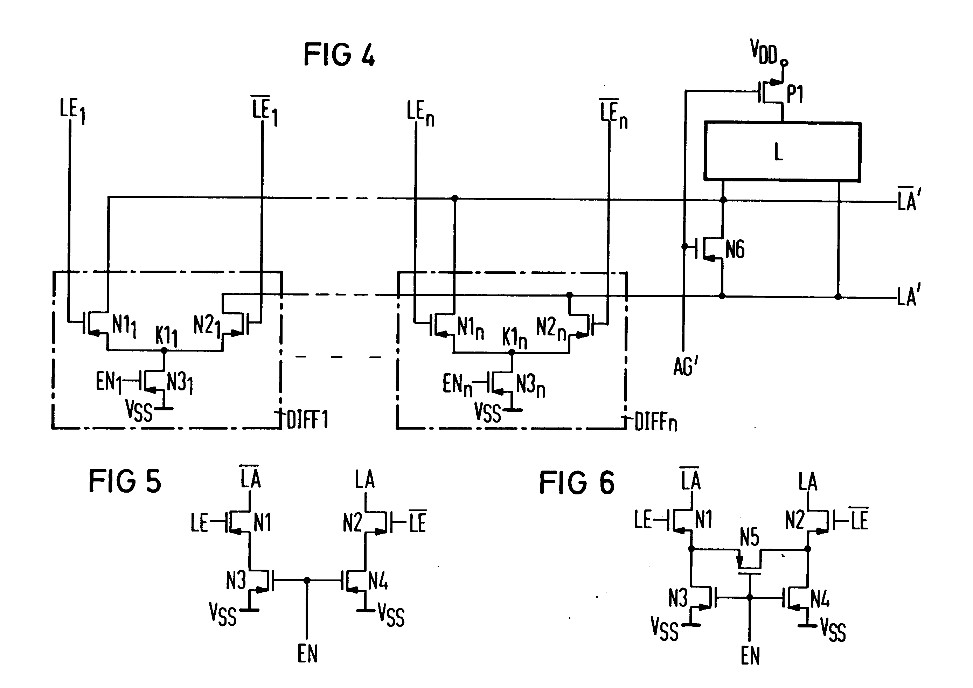

Während in der ersten Veröffentlichung ein 4Kx4 CMOS-statischer RAM, der mit einer einzigen Polysiliziumschicht hergestellt wird, wiedergegeben ist, wird in der zweiten Veröffentlichung ein sehr schneller 2Kx8 Bit CMOS SRAM vorgestellt, der eine Zugriffszeit von 16 ns ermöglicht, die vergleichbar ist mit bipolaren SRAMs gleicher Größenordnung. In beiden Veröffentlichungen sind Schaltungen für einen Leseverstärker mit Lastteil sowie den eigentlichen Speicherzellenteil (Fig. 10 in Veröffentlichung 1) und Fig. 6 in Veröffentlichung 2) beschrieben).

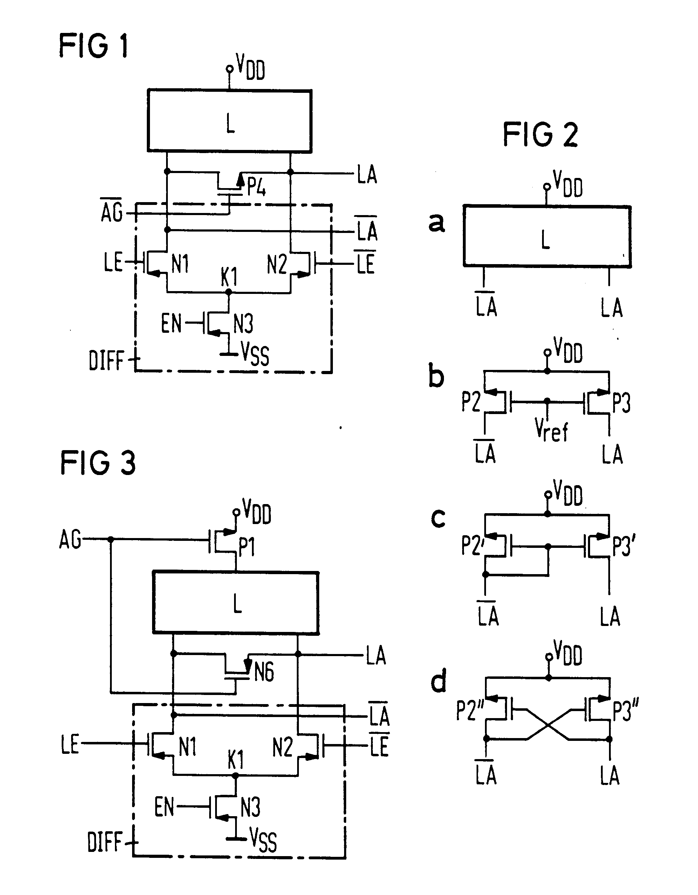

In den Figuren 1 und 2, mit Ausnahme von Fig. 2c in Verbindung mit Fig. 1, der vorliegenden Anmeldung ist nochmals der Stand der Technik für solche Leseverstärker abgebildet. Der Leseverstärker wird hier in einen p-Kanallastteil und einen Differenzverstärkerteil unterteilt, wobei für den p-Kanallastteil mehrere Schaltungsmöglichkeiten existieren. Der Differenzverstärkerteil besteht aus drei in herkömmlicher Weise verschalteten n-Kanal-Feldeffekttransistoren, mit einem zusätzlichen p-Kanal-Ausgleichstransistor. Bei getakteten Speichern mit Vorladephase verbessert dieser Ausgleichstransistor bei den ersten beiden Lastteilschaltungen (Fig. 2b, c) den Ausgleich der Leseverstärkerausgänge LA und L̅A̅ während der Vorladephase. Das Einschalten des Ausgleichstransistors (P4) während der Vorladephase und das Abschalten während der Bewertungsphase wird über ein Signal am Eingang A̅G̅ gesteuert.

Bei den in den Figuren 2b, c, d angeführten unterschiedlichen Lastteilen für einen Leseverstärker stellt sich während der Vorladephase (A̅G̅ = "0", EN = "0") an den Ausgängen LA und L̅A̅ das Vorladepotential V_{DD} bzw. V_{DD} - V_{THP} ein. Hierbei kennzeichnet V_{THP} (ca. 0,8 V) die Schwellspannung eines p-Kanal-Transistors. Ein solch hohes Vorladepotential ist jedoch für kurze Zugriffszeiten ungünstig.

Der Erfindung liegt die Aufgabe zugrunde, einen Leseverstärker vorzustellen, der sehr kurze Zugriffszeiten ermöglicht.

Diese Aufgabe wird durch die Merkmale des unabhängigen Anspruchs 1 gelöst.

Weitere Ausgestaltungen, insbesondere der zugehörigen Lastteile und Differenzverstärkerteile sind Gegenstand der Unteransprüche.

Ausführungsbeispiele der Erfindung sind in den Zeichnungen Figur 3 bis 6 dargestellt und werden im folgenden näher beschrieben. Es zeigen:
- Figur 1: den Stand der Technik bei Leseverstärkern für statische CMOS-Speicher,
- Figur 2a bis d: den Lastteil für einen Leseverstärker, wobei in den Figuren 2b bis d Realisierungsmöglichkeiten angegeben sind,
- Figur 3: einen erfindungsgemäßen Leseverstärker mit Vorladung der Ausgänge LA und L̅A̅ auf mittleres Potential,
- Figur 4: einen erfindungsgemäßen Leseverstärker mit Vorladung der Ausgänge LA und L̅A̅ auf mittleres Potential sowie mit zusätzlicher Spaltenkodierung,
- Figur 5 und 6: Schaltungsvarianten für den Differenzverstärkerteil des Leseverstärkers, bei dem das Querstromproblem in den Ausgängen des Leseverstärkers LA und L̅A̅ nicht auftritt.

Der Stand der Technik bei Leseverstärkern für statische CMOS-Speicher ist in Figur 1 dargestellt. Dieser Leseverstärker besteht aus einem Lastteil L, einem Differenzverstärkerteil DIFF sowie einem Ausgleichstransistor, der als p-Kanal-Feldeffekttransistor P4 ausgebildet ist. Der Lastteil L ist zum einen mit einer Spannung V_{DD}, zum anderen über zwei Verbindungsleitungen, die zugleich die zwei Ausgänge des Leseverstärkers LA, L̅A̅ darstellen, mit dem Differenzverstärkerteil DIFF verbunden. Zwischen Lastteil L und dem Differenzverstärkerteil DIFF ist der p-Kanal-Ausgleichstransistor P4 angeordnet, dessen Gateanschluß den ersten Schalteingang A̅G̅ bildet und der mit seinem Sourceanschluß an den ersten Ausgang LA und sein Drainanschluß mit dem zweiten Ausgang L̅A̅ des Leseverstärkers verschaltet ist. Der Differenzverstärkerteil DIFF besteht aus drei in herkömmlicher Weise verschalteter n-Kanal-Feldeffekttransistoren N1, N2, N3, wobei der Sourceanschluß des ersten n-Kanal-Feldeffekttransistors N1 und der Sourceanschluß des zweiten n-Kanal-Feldeffekttransistors N2 über einen gemeinsamen Anschluß K1 mit dem Drainanschluß des dritten n-Kanal-Feldeffekttransistors N3 verbunden ist. Der Sourceanschluß des dritten n-Kanal-Feldeffekttransistors N3 ist an Masse V_{SS} angeschlossen, während der Gateanschluß desselbigen Transistors den zweiten Schalteingang EN bildet. Der Gateanschluß des ersten Feldeffekttransistors N1 sowie der Gateanschluß des zweiten Feldeffekttransistors N2 bilden je den ersten und zweiten Eingang des Leseverstärkers LE, L̅E̅. Der Drainanschluß des ersten und zweiten n-Kanal-Feldeffekttransistors N1, N2 ist weiterhin mit je einem Ausgang des Leseverstärkers LA, L̅A̅ verbunden.

In Figur 2a ist nochmals der Lastteil L mit seinen Anschlüssen zur Spannung V_{DD} und zu den Ausgängen des Leseverstärkers LA, L̅A̅ dargestellt. Die Figuren 2b, c, d geben Realisierungsmöglichkeiten für diesen Lastteil L an. Der in Figur 2b wiedergegebene Lastteil besteht aus einem ersten und zweiten p-Kanal-Feldeffekttransistor P2, P3, die jeweils gleich dimensioniert sind und als reine Lastelemente in der Schaltung Verwendung finden, sie leisten keinen aktiven Beitrag zur Verstärkung. Der Sourceanschluß des ersten und zweiten p-Kanal-Feldeffekttransistors P2, P3 ist gemeinsam auf eine Spannung V_{DD} gelegt, während der Gateanschluß des ersten und zweiten p-Kanal-Feldeffekttransistors an einer gemeinsamen Referenzspannung V_{Ref} liegt. Die Drainanschlüsse der beiden p-Kanal-Feldeffekttransistoren bilden die zwei Ausgänge des Lastteils und in Verbindung mit dem Differenzverstärkerteil und dem Ausgleichstransistors die beiden Ausgänge des Leseverstärkers LA, L̅A̅.

Eine über den Stand der Technik hinausgehende Kombination stellt die Zusammenschaltung eines Leseverstärkers aus der Figur 1 in Verbindung mit einem Lastteil der Figur 2c dar. Figur 2c zeigt eine stromspiegelartige Verschaltung, bei der die Gateanschlüsse des ersten und zweiten p-Kanal-Feldeffekttransistors P2′, P3′ mit dem Draingebiet des ersten p-Kanal-Feldeffekttransistors P2′ und somit mit einem Ausgang des Lastteils L̅A̅ verbunden sind. Hier hat man bereits eine zusätzliche Kopplung der Potentialverschiebung am Ausgang L̅A̅ auf den Ausgang LA über den Lastteil mittels des zweiten p-Kanal-Feldeffekttransistors P3′. Umgekehrt ist keine Kopplung vom Ausgang LA auf den Ausgang L̅A̅ über den Lastteil L vorhanden. Ähnlich wie in Figur 2b sind die Sourceanschlüsse der beiden p-Kanal-Feldeffekttransistoren P2′, P3′ mit einer Spannung V_{DD} verschaltet und die Drainanschlüsse des ersten und zweiten p-Kanal-Feldeffekttransistors bilden die beiden Ausgänge L̅A̅, LA.

Figur 2d zeigt eine Realisierung des Lastteils L, bei der eine echte Mitkopplung realisiert ist. In dieser dritten Variante des Lastteils sind die Sourceanschlüssen der beiden p-Kanal-Feldeffekttransistoren P2˝, P3˝ wieder an die Spannung V_{DD} gelegt und die beiden Drainanschlüsse der beiden p-Kanal-Feldeffekttransistoren bilden die beiden Ausgänge LA, L̅A̅ des aus Lastteil L, Differenzverstärkerteil DIFF und Ausgleichstransistor P4 gebildeten Leseverstärker. Neben der Verbindung des Gateanschlusses des p-Kanal-Feldeffekttransistors P3˝ mit dem Ausgang L̅A̅ ist als weitere Kopplung über den Lastteil auch eine Verbindung des Ausgangs LA mit dem Gateanschluß des p-Kanal-Feldeffekttranistors P2˝ vorhanden.

Die einzelnen Varianten Figur 2b, c, d bieten mit zunehmender Anzahl von Kopplungen über den Lastteil eine immer größer werdende Verstärkung. Während allerdings die Varianten Fig. 2b und 2c nur einen stabilen Ausgangszustand haben, liegt in der Variante Fig. 2d bereits ein bistabiles Element vor, bei dem nach jeder Bewertung ein Potentialausgleich der Ausgänge LA und L̅A̅ erfolgen muß und bei dem der dritte n-Kanal-Feldeffekttransistor N3 bei der Bewertung nicht zu früh eingeschaltet werden darf. In den drei Varianten 2b, 2c, 2d sind die beiden p-Kanal-Feldeffekttransistoren jeweils gleich dimensioniert.

Die Eingänge des Leseverstärkers sind mit LE und L̅E̅ bezeichnet. Diese Eingänge können direkt durch das Bitleitungspaar einer Speicherspalte oder durch die Ausgänge einer Spaltenvordecodierung bzw. Vorverstärkerstufe gebildet werden. Die Eingänge LE und L̅E̅ sind auf die Gateanschlüsse der gleichdimensionierten n-Kanal-Feldeffekttransistoren N1 und N2 geführt, deren Drainanschlüsse an die Verstärkerausgänge LA und L̅A̅ angeschlossen sind und deren Sourcegebiete im Knoten K1 zusammengeführt werden. Mit dem Einschaltsignal EN am Gate des n-Kanal-Feldeffekttransistors N3 zwischen dem Knoten K1 und der Masse V_{SS} wird der Leseverstärker ein- bzw ausgeschaltet. Im Normalfall werden beim Einschalten am Eingang EN 5 Volt angelegt. Es gibt aber auch Speicherentwürfe, die eine gegen Prozeßschwankungen korrigierte Referenzspannung (<5 Volt) benutzen und somit eine bessere Stromquelle realisieren.

Bei den in Figur 1 in Verbindung mit den Figuren 2a bis 2d dargestellten Leseverstärkern stellt sich während der Vorladephase, in diesem Falle liegt an den Eingangen A̅G̅ "0", EN "0", an den Ausgangsknoten LA, L̅A̅ das Vorladepotential V_{DD} bzw. V_{DD}-V_{THP} ein. Hierbei ist V_{THP} (typischer Wert ca. 0,8 Volt) die Schwellspannung eines p-Kanal-Feldeffekttransistors.

Will man bei einem Speicher kurze Zugriffszeiten erreichen, so ist es vorteilhaft, wenn man die Schaltschwelle nachfolgender Gatter (z.B. Ausgangstreiber, Latcheingang) an das Vorladepotential des Leseverstärkers anpaßt. Ein hohes Vorladepotential von etwa 5 Volt bzw. 4,2 Volt, wie es bei den Leseverstärkern nach Figur 1 in Verbindung mit Figuren 2a bis 2d der Fall ist, ist hierbei ungünstig.

Wünschenswert wäre ein Leseverstärker, dessen Vorladepotential an den Ausgängen LA, L̅A̅ bei etwa 2,5 Volt liegt. Ein solcher Leseverstärker ist in der Figur 3 dargestellt. Es handelt sich um einen erfindungsgemäßen Leseverstärker mit Vorladung der Ausgänge LA, L̅A̅ auf mittleres Potential. Wie in Figur 1 ist dieser Leseverstärker aus einem Lastteil L, einem Differenzverstärker DIFF und einem Ausgleichstransistor N6 aufgebaut, der hier im Gegensatz zu dem Ausgangstransistor P4 in Figur 1 aus einem n-Kanal-Feldeffekttransistor besteht. Die Verschaltung von Lastteil L, Ausgleichstransistor N6 sowie des Differenzverstärkerteils DIFF erfolgt analog wie in Figur 1, wobei die gleichen Bezugszeichen von Figur 1 auch in Figur 3 Verwendung finden, jedoch ist der Gateanschluß des Ausgleichstransistors N6 mit dem Gateanschluß eines zusätzlichen p-Kanal-Feldeffekttransistors P1 verbunden, und beide Gateanschlüsse bilden gemeinsam den Schalteingang AG. Der zusätzliche p-Kanal-Feldeffekttransistor P1 ist zwischen der Betriebsspannung V_{DD} und dem p-Kanal-Lastteil eingefügt. Dieser Transistor hat die Funktion eines Schalters, der während der Vorladephase, in diesem Falle sind die Eingänge AG "1", EN "0", die Betriebsspannung V_{DD} abtrennt und sie während der Bewertungsphase, in diesem Falle sind die Eingänge AG "0", EN "1", einschaltet. Als Lastteile L können die schon in Figur 2b bis 2d vorgestellten Lastteile eingesetzt werden.

In der Vorladephase, in diesem Falle sind die Eingänge AG "1", EN "0", sind die Feldeffekttransistoren P1 und N3 nicht leitend, und der Ausgleichstransistors N6 ist leitend geschaltet. Hiermit sind beide Versorgungsspannungen, V_{DD} und V_{SS} (= Masse) abgetrennt und das Vorladepotential stellt sich durch den Ausgleich der Kapazitäten an den Ausgängen des Leseverstärkers LA, L̅A̅ ein. Bestimmend fär das Vorladepotential an den Ausgängen LA, L̅A̅ sind deshalb neben dem Wert der Kapazitäten an diesen Ausgängen auch der Gleichgewichtszustand bei den eingeschalteten Transistoren P1 und N3 sowie die Symmetrie des Hubs beim Bewertungsvorgang. Der Gleichgewichtszustand kann durch die Wahl der relativen Weiten von p- und n-Kanal-Transistoren auf einen mittleren Wert gebracht werden. Die Kapazitäten an den Ausgängen LA, L̅A̅ können durch ein symmetrisches Design gleichgemacht werden. Der durch die p-Kanal-Lastteile nach Figur 2b und 2d erzeugte Hub ist ebenfalls symmetrisch. Nur der angeschlossene p-Kanal-Lastteil nach Figur 2c liefert einen unsymmetrischen Hub. Hier ergeben sich aus diesem Grunde zwei verschiedene Vorladepotentiale, von denen eines etwas oberhalb und eines etwas unterhalb des Mittelwertes liegt. Das Vorladepotential, auf welches vorgeladen wird, ist durch den vorangegangenen Bewertungsvorgang bestimmt.

Die Wahl eines n-Kanal-Feldeffekttransistors N6 als Ausgleichstransistor, im Gegensatz zu dem Ausgleichstransistor nach Figur 1, ist dadurch begründet, daß in der Schaltung nach Figur 3 die Vorladung auf ein mittleres Potential (ca. 2,5 Volt) erfolgt. Hier erhält man mit einem n-Kanal-Feldeffekttransistor einen schnelleren Ausgleich. Bei hohem Ausgleichspotential, wie er in der Schaltung nach Figur 1 auftritt, arbeitet dagegen ein p-Kanal-Feldeffekttransistor schneller.

Die Lastteilvarianten nach Figur 2b bis 2d, die sowohl in den Leseverstärker nach Figur 3 und Figur 1 Verwendung finden, können ebenfalls kombiniert werden, falls dies bei einem Anwendungsfall sich als günstig erweist. Beispielsweise kann ein Lastteil nach Figur 2b und zusätzlich ein Lastteil nach Figur 2d an die Leseverstärkerausgänge LA und L̅A̅ angeschlossen werden.

Figur 4 zeigt einen erfindungsgemäßen Leseverstärker mit Vorladung der Ausgänge LA, L̅A̅ auf ein mittleres Potential und zusätzlicher Spaltencodierung. In diesem Falle schaltet man die Ausgänge LA, L̅A̅ mehrerer Leseverstärker auf einen gemeinsamen Bus.

Für den Aufbau dieses Leseverstärkers wird lediglich der Differenzverstärkerteil n mal ausgelegt, während der Lastteil L, der n-Kanal-Ausgleichstransistor N6 sowie der p-Kanal-Feldeffekttransistor P1, der zwischen der Betriebsspannung V_{DD} und dem Lastteil L eingefügt ist, nur einmal aufzubauen sind. Die Realisierung der n Differenzverstärkerteile DIFF1...DIFFn ist analog zu dem Differenzverstärkerteil DIFF aus Figur 1 und Figur 3 durchzuführen. Jeder dieser Differenzverstärkerteile besteht aus je drei n-Feldeffekttransistoren N1₁, N2₁, N3₁... N1ₙ, N2ₙ, N3ₙ. Die Eingangssignale für den Leseverstärker werden für den ersten Differenzverstärker DIFF1 über die Eingänge LE₁ bzw. L̅E̅₁ an die Gateanschlüsse der n-Kanal-Feldeffekttrasistoren N1₁, N2₁ angelegt. Analog sind die Eingänge LEn bzw. L̅E̅n des n-ten Differenzverstärkers DIFFn mit dem Gateanschluß des n-Kanal-Feldeffekttransistors N1ₙ bzw. N2ₙ verschaltet. Je einer der zwei Ausgängen eines jeden Differenzverstärkerteils DIFF1...DIFFn sind untereinander parallel verschaltet und bilden die Ausgänge LA′ bzw. L̅A̅′. Analog wie in den Figuren 1 und 3 wird der n-Kanal-Ausgleichstransistor N6 und der p-Kanal-Feldeffekttransistor P1 verschaltet, dessen Gateanschlüsse gemeinsam den ersten Schalteingang AG′ bilden. Ebenfalls wie in den Differenzverstärkerteilen der Figuren 1 und 3 bilden die Gateanschlüsse des dritten n-Kanal-Feldeffekttransistors N3₁...N3ₙ den zweiten Schalteingang EN₁... ENₙ des entsprechenden Differenzverstärkerteils DIFF1...DIFFn.

Die Leseverstärker mit Spaltendecodierung nach Figur 4 haben einen Schwachpunkt, der sich in speziellen Anwendungsfällen (z.B. dann wenn sehr viele Differenzverstärkerteile zusammengeschaltet werden) bemerkbar machen kann. Dieser Schwachpunkt besteht darin, daß über die Knoten K1₁...K1ₙ der Differenzverstärkerteile, deren dritter Feldeffekttransistor N3₁...N3ₙ nicht aktiviert sind, ein Querstrom zwischen den Ausgängen des Leseverstärkers LA′, L̅A̅′ fließen kann. Durch einen solchen Querstrom wird der maximale Signalhub begrenzt. Die Figuren 5 und 6 zeigen zwei Schaltungsvorschläge, bei denen das Querstromproblem nicht auftritt.

Figur 5 zeigt einen Differenzverstärkerteil, bestehend aus vier n-Kanal-Feldeffekttransistoren N1, N2, N3 und N4, wobei die ersten beiden n-Kanal-Feldeffekttransistoren N1, N2 mit ihren Drainanschlüssen die Ausgänge LA bzw. L̅A̅ und die Gateanschlüsse derselben Feldeffekttransistoren wiederum die Eingänge LE bzw. L̅E̅ des aufzubauenden Leseverstärkers bilden. Der Sourceanschluß des Feldeffekttransistors N1 ist mit dem Drainanschluß eines dritten n-Kanal-Feldeffekttransistors N3 und über dessen Sourceanschluß an die Masse V_{SS} angeschlossen, ebenso ist der zweite n-Kanal-Feldeffekttransistor N2 mit seinem Sourceanschluß an den Drainanschluß des vierten n-Kanal-Feldeffekttransistors N4 angeschlossen und über dessen Sourceanschluß mit der Masse V_{SS} verbunden. Der Schalteingang EN, der in den Differenzverstärkerteilen nach Figur 1, 3 und 4 jeweils mit dem Gateanschluß eines Feldeffekttransistors verbunden war, ist in Figur 5 mit den Gateanschlüssen des dritten und vierten Feldeffekttransistors N3 und N4 verschaltet.

Der Differenzverstärkerteil nach Figur 6 ist analog zu dem nach Figur 5 aufgebaut, jedoch wird ein fünfter n-Kanal-Feldeffekttransistor N5 zusätzlich eingebaut. Dieser fünfte n-Kanal-Feldeffekttransistor ist mit seinem Sourceeingang mit dem Sourceeingang des ersten n-Kanal-Feldeffekttransistors N1 und mit dem Drainanschluß des dritten n-Kanal-Feldeffekttransistors N3 und mit seinem Drainanschluß mit dem Sourceanschluß des zweiten n-Kanal-Feldeffekttransistors N2 und dem Drainanschluß des vierten n-Kanal-Feldeffekttransistors N4 verschaltet. Der Gateanschluß dieses fünften n-Kanal-Feldeffekttransistors ist mit den Gateanschlüssen des dritten und vierten n-Kanal-Feldeffekttransistors N3, N4 verbunden und bildet gemeinsam den Schalteingang EN.

Mit Hilfe der zusätzlichen Feldeffekttransistoren N3 und N4 in Figur 5 bzw. der Feldeffekttransistoren N3, N4 und N5 nach Figur 6 ist es möglich, einen Querstrom zwischen den Ausgängen L̅A̅ und LA durch ein Signal am Schalteingang EN zu unterdrücken.

## Patentansprüche

1. Leseverstärker, bestehend aus mindestens einem Lastteil (L), mindestens einem Differenzverstärkerteil (DIFF) und einem Ausgleichstransistor (N6),
**dadurch gekennzeichnet,**
daß zwischen dem Lastteil (L) und einer Spannung V_{DD} ein Schalttransistor (P1) vorgesehen ist, daß ein Gateanschluß des Schalttransistors (P1) mit einem Gateanschluß des Ausgleichstransistors (N6) gemeinsam einen ersten Schalteingang (AG) bilden, daß der Schalttransistor (P1) ein p-Kanal-Feldeffekttransistor ist, der mit einem Sourceanschluß an die Spannung (V_{DD}) und mit einem Drainanschluß an dem Lastteil (L) angeschlossen ist, und daß der Ausgleichstransistors (N6) ein n-Kanal-Feldeffekttransistor ist, der mit einem Sourceanschluß an den ersten (LA) und mit einem Drainanschluß an den zweiten Ausgang (L̅A̅) des Leseverstärkers angeschlossen ist.

2. Leseverstärker nach Anspruch 1,
**dadurch gekennzeichnet,**
daß M (M = ganze Zahl) Lastteile vorgesehen sind, die parallel mit einander verbunden sind.

3. Leseverstärker nach Anspruch 2,
**dadurch gekennzeichnet,**
daß für einen Lastteil (L) ein erster und zweiter p-Kanal-Feldeffekttransistor (P2, P2', P2''; P3, P3', P3'') vorgesehen ist, daß Sourceanschlüsse der p-Kanal-Feldeffekttransistoren (P2,P2', P2''; P3, P3', P3'') mit dem Drainanschluß des Schalttransistors (P1) verschaltet sind, daß der Drainanschluß des ersten und zweiten p-Kanal-Feldeffekttransistors (P2, P2', P2''; P3, P3', P3'') den ersten und zweiten Ausgang des Leseverstärkers (LA, L̅A̅) bilden.

4. Leseverstärker nach Anspruch 3,
**dadurch gekennzeichnet,**
daß Gateanschlüsse des ersten und zweiten p-Kanal-Feldeffekttransistors (P2, P3) an eine Referenzspannung (V_{Ref}) angeschlossen sind.

5. Leseverstärker nach Anspruch 3,
**dadurch gekennzeichnet,**
daß Gateanschlüsse des ersten und zweiten p-Kanal-Feldeffekttransistors (P2', P3') an den Drainanschluß des ersten p-Kanal-Feldeffekttransistors (P2') angeschlossen sind.

6. Leseverstärker nach Anspruch 3,
**dadurch gekennzeichnet,**
daß ein Gateanschluß des ersten p-Kanal-Feldeffekttransistors (P2'') mit einem Drainanschluß des zweiten p-Kanal-Feldeffekttransistors (P3'') und ein Gateanschluß des zweiten p-Kanal-Feldeffekttransistors (P3'') mit einem Drainanschluß des ersten p-Kanal-Feldeffekttransistors (P2'') verbunden ist.

7. Leseverstärker nach einem der Ansprüche 1 bis 6,
**dadurch gekennzeichnet,**
daß n (n = ganze Zahl) parallel geschaltete Differenzverstärkerteile vorgesehen sind, daß für einen Differenzverstärkerteil mindestens drei n-Kanal-Feldeffekttransistoren (N1ᵢ, N2ᵢ, N3ᵢ, i = 1...n) vorgesehen sind, daß ein Drainanschluß des ersten bzw. zweiten n-Kanal-Feldeffekttransistors (N1ᵢ, N2ᵢ) der n Differenzverstärkerteile mit dem ersten bzw. zweiten Ausgang des Leseverstärkers (LA, L̅A̅) verschaltet ist, daß je ein Gateanschluß des ersten und des zweiten n-Kanal-Feldeffekttransistors (N1ᵢ, N2ᵢ) der n Differenzverstärkerteile einen Eingang des Leseverstärkers (LEᵢ, L̅E̅ᵢ) bilden.

8. Leseverstärker nach Anspruch 7,
**dadurch gekennzeichnet,**
daß im Differenzverstärkerteil die Sourceanschlüsse des ersten und zweiten n-Kanal-Feldeffekttransistors (N1ᵢ, N2ᵢ) mit einem Drainanschluß des dritten n-Kanal-Feldeffekttransistors (N3ᵢ) verschaltet sind, daß ein Gateanschluß des dritten n-Kanal-Feldeffekttransistors (N3ᵢ) einen zweiten Schalteingang (ENᵢ) bildet, daß ein Sourceanschluß des dritten n-Kanal-Feldeffekttransistors (N3ᵢ) mit der Masse (V_{SS}) verbunden ist.

9. Leseverstärker nach Anspruch 7,
**dadurch gekennzeichnet,**
daß im Differenzverstärkerteil der Sourceanschluß des ersten n-Kanal-Feldeffekttransistors (N1) mit dem Drainanschluß des dritten n-Kanal-Feldeffekttransistors (N3) und der Sourceanschluß des zweiten n-Kanal-Feldeffekttransistors (N2) mit einem Drainanschluß des vierten n-Kanal-Feldeffekttransistors (N4) verschaltet ist, daß Gateanschlüsse des dritten und vierten n-Kanal-Feldeffekttransistors (N3, N4) einen zweiten Schalteingang (EN) bilden, daß Sourceanschlüsse des dritten und vierten n-Kanal-Feldeffekttransistors (N3, N4) mit der Masse (V_{SS}) verschaltet sind.

10. Leseverstärker nach Anspruch 9,
**dadurch gekennzeichnet,**
daß im Differenzverstärkerteil ein fünfter n-Kanal-Feldeffekttransistor (N5) vorgesehen ist, daß ein Sourceanschluß des fünften n-Kanal-Feldeffekttransistors (N5) mit dem Sourceanschluß des ersten n-Kanal-Feldeffekttransistors (N1), ein Drainanschluß des fünften n-Kanal-Feldeffekttransistors (N5) mit dem Sourceanschluß des zweiten n-Kanal-Feldeffekttransistors (N2) und ein Gateanschluß des fünften n-Kanal-Feldeffekttransistors (N5) mit den Gateanschlüssen des dritten und vierten n-Kanal-Feldeffekttransistors (N3, N4) verbunden sind.

## Claims

1. Read amplifier comprising at least one load section (L), at least one differential amplifier section (DIFF) and one compensating transistor (N6), characterised in that a switching transistor (P1) is provided between the load section (L) and a voltage V_{DD}, in that a gate terminal of the switching transistor (P1) together with a gate terminal of the compensating transistor (N6) jointly form [sic] a first switching input (AG), in that the switching transistor (P1) is a p-channel field-effect transistor, a source terminal of which is connected to the voltage (V_{DD}) and a drain terminal of which is connected to the load section (L), and in that the compensating transistor (N6) is an n-channel field-effect transistor, a source terminal of which is connected to the first output (LA) of the read amplifier and a drain terminal of which is connected to its second output (L̅A̅).

2. Read amplifier according to Claim 1, characterised in that M (M = integer) load sections are provided which are connected in parallel with one another.

3. Read amplifier according to Claim 2, characterised in that a first p-channel field-effect transistor (P2, P2', P2") and a second p-channel field-effect transistor (P3, P3', P3") are provided for a load section (L), in that source terminals of the p-channel field-effect transistors (P2, P2', P2"; P3, P3', P3") are connected to the drain terminal of the switching transistor (P1), and in that the drain terminal of the first p-channel field-effect transistor (P2, P2', P2") and second p-channel field-effect transistor (P3, P3', P3") form the first output (LA) and second output (L̅A̅) of the read amplifier.

4. Read amplifier according to Claim 3, characterised in that the gate terminals of the first p-channel field-effect transistor (P2) and second p-channel field-effect transistor (P3) are connected to a reference voltage (V_{Ref}).

5. Read amplifier according to Claim 3, characterised in that gate terminals of the first p-channel field-effect transistor (P2') and second p-channel field-effect transistor (P3') are connected to the drain terminal of the first p-channel field-effect transistor (P2').

6. Read amplifier according to Claim 3, characterised in that a gate terminal of the first p-channel field-effect transistor (P2") is connected to a drain terminal of the second p-channel field-effect transistor (P3") and a gate terminal of the second p-channel field-effect transistor (P3") is connected to a drain terminal of the first p-channel field-effect transistor (P2").

7. Read amplifier according to one of Claims 1 to 6, characterised in that n (n = integer) parallel-connected differential amplifier sections are provided, in that at least three n-channel field-effect transistors (N1ᵢ, N2ᵢ, N3ᵢ, i = 1...n) are provided for a differential amplifier section, in that a drain terminal of the first or second n-channel field-effect transistor (N1ᵢ, N2ᵢ) of the n differential amplifier sections are connected to the first or second output, respectively, of the read amplifier (LA,L̅A̅), and in that a gate terminal in each case of the first n-channel field-effect transistor (N1ᵢ) and of the second n-channel field-effect transistor (N2ᵢ) of the n-differential amplifier sections form an input of the read amplifier (LEᵢ, L̅E̅ᵢ).

8. Read amplifier according to Claim 7, characterised in that, in the differential amplifier section, the source terminals of the first n-channel field-effect transistor (N1ᵢ) and second n-channel field-effect transistor (N2ᵢ) are connected to a drain terminal of the third n-channel field-effect transistor (N3ᵢ), in that a gate terminal of the third n-channel field-effect transistor (N3ᵢ) forms a second switching input (ENᵢ), and in that a source terminal of the third n-channel field-effect transistor (N3ᵢ) is connected to earth (V_{SS}).

9. Read amplifier according to Claim 7, characterised in that, in the differential amplifier section, the source terminal of the first n-channel field-effect transistor (N1) is connected to the drain terminal of the third n-channel field-effect transistor (N3) and the source terminal of the second n-channel field-effect transistor (N2) is connected to a drain terminal of the fourth n-channel field-effect transistor (N4), in that gate terminals of the third n-channel field-effect transistor (N3) and fourth n-channel field-effect transistor (N4) form a second switching input (EN), and in that source terminals of the third n-channel field-effect transistor (N3) and fourth n-channel field-effect transistor (N4) are connected to earth (Vₛₛ).

10. Read amplifier according to Claim 9, characterised in that, in the differential amplifier section, a fifth n-channel field-effect transistor (N5) is provided, in that a source terminal of the fifth n-channel field-effect transistor (N5) is connected to the source terminal of the first n-channel field-effect transistor (N1), a drain terminal of the fifth n-channel field-effect transistor (N5) is connected to the source terminal of the second n-channel field-effect transistor (N2) and a gate terminal of the fifth n-channel field-effect transistor (N5) is connected to the gate terminals of the third n-channel field-effect transistor (N3) and fourth n-channel field-effect transistor (N4).

## Revendications

1. Amplificateur de lecture, constitué par au moins une partie de charge (L), au moins une partie formant amplificateur différentiel (DIFF) et un transistor de compensation (N6),
caractérisé par le fait qu'un transistor de commutation (P1) est disposé entre la partie formant charge (L) et une alimentation V_{DD}, qu'une borne de grille du transistor de commutation (P1) forme, conjointement avec une borne de grille du transistor de compensation (N6), une première entrée de commutation (AG), que le transistor de commutation (P1) est un transistor à effet de champ à canal p, qui est raccordé par une borne de source à la tension (V_{DD}) et par une borne de drain à la partie formant charge (L), et que le transistor de compensation (N6) est un transistor à effet de champ à canal n, qui est connecté par une borne de source à la première sortie (LA) et par une borne de drain à la seconde sortie (L̅A̅) de l'amplificateur de lecture.

2. Amplificateur de lecture suivant la revendication 1, caractérisé par le fait qu'il est prévu M (M = nombre entier) parties formant charges, qui sont branchées en parallèle.

3. Amplificateur de lecture suivant la revendication 2, caractérisé par le fait que pour une partie formant charge (L), il est prévu des premier et second transistors à effet de champ à canal p (P2, P2', P2"; P3, P3', P3"), que les bornes de source des transistors à effet de champ à canal p (P2, P2', P2"; P3, P3', P3") sont raccordées à la borne de drain du transistor de commutation (P1), et que les bornes de drain des premier et second transistors à effet de champ à canal p (P2, P2', P2"; P3, P3', P3") forment les première et seconde sorties de l'amplificateur de lecture (LA, L̅A̅).

4. Amplificateur de lecture suivant la revendication 3, caractérisé par le fait que les bornes de grille des premier et second transistors à effet de champ à canal p (P2, P3) sont raccordées à une tension de référence (V_{Ref}).

5. Amplificateur de lecture suivant la revendication 3, cractérisé par le fait que des bornes de grille des premier et second transistors à effet de champ à canal p (P2', P3') sont raccordées à la borne de drain du premier transistor à effet de champ à canal p (P2').

6. Amplificateur de lecture suivant la revendication 3, caractérisé par le fait qu'une borne de grille du premier transistor à effet de champ à canal p (P2") est raccordée à une borne de drain du second transistor à effet de champ à canal p (P3") et qu'une borne de grille du second transistor à effet de champ à canal p (P3") est raccordée à une borne de drain du premier transistor à effet de champ à canal p (P2").

7. Amplificateur de lecture suivant l'une des revendications 1 à 6, caractérisé par le fait qu'il est prévu n (n = nombre entier) parties formant amplificateurs différentiels, branchées en parallèle, que pour une partie formant amplificateur différentiel, il est prévu au moins trois transistors à effet de champ à canal n (N1ᵢ, N2ᵢ, N3ᵢ, i = 1 ... n), qu'une borne de drain du premier ou du second transistor à effet de champ à canal n (N1ᵢ, N2ᵢ) des n parties formant amplificateurs différentiels est raccordée à la première ou à la seconde sortie de l'amplificateur différentiel (LA, L̅A̅), et que respectivement une borne de grille des premier et second transistors à effet de champ à canal n (N1ᵢ, N2ᵢ) des n parties formant amplificateurs différentiels forme une entrée de l'amplificateur de lecture (LEᵢ, L̅E̅ᵢ).

8. Amplificateur de lecture suivant la revendication 7, caractérisé par le fait que dans la partie formant amplificateur différentiel, les bornes de source des premier et second transistors à effet de champ à canal n (N1ᵢ, N2ᵢ) sont raccordées à la borne de drain du troisième transistor à effet de champ à canal n (N3ᵢ), qu'une borne de grille du troisième transistor à effet de champ à canal n (N3ᵢ) forme une seconde entrée de commutation (ENᵢ), et qu'une borne de source du troisième transistor à effet de champ à canal n (N3ᵢ) est raccordée à la masse (V_{SS}).

9. Amplificateur de lecture suivant la revendication 7, caractérisé par le fait que dans la partie formant amplificateur différentiel, la borne de source du premier transistor à effet de champ à canal n (N1) est raccordée à la borne de drain du troisième transistor à effet de champ à canal n (N3) et que la borne de source du second transistor à effet de champ à canal n (N2) est raccordée à une borne de drain du quatrième transistor à effet de champ à canal n (N4), que les bornes de grille des troisième et quatrième transistors à effet de champ à canal n (N3, N4) forment une seconde entrée de commutation (EN), et que les bornes de source des troisième et quatrième transistors à effet de champ à canal n (N3, N4) sont raccordées à la masse (V_{SS}).

10. Amplificateur de lecture suivant la revendication 9, caractérisé par le fait que dans la partie formant amplificateur différentiel, est prévu un cinquième transistor à effet de champ à canal n (N5), qu'une borne de source du cinquième transistor à effet de champ à canal n (N5) est raccordée à la borne de source du premier transistor à effet de champ à canal n (N1), qu'une borne de drain du cinquième transistor à effet de champ à canal n (N5) est raccordée à la borne de source du second transistor à effet de champ à canal n (N2) et qu'une borne de grille du cinquième transistor à effet de champ à canal n (N5) est raccordée aux bornes de grille des troisième et quatrième transistors à effet de champ à canal n (N3, N4).
